# EUROPEAN PATENT APPLICATION

(11) **EP 4 557 349 A1**
(43) Date of publication of application: **21.05.2025**
(21) Application number: 23839577.6
(22) Date of filing: 07.07.2023
(51) Int. Cl.: H01L 21/31, C23C 16/44, H01L 21/3065

(54) **VACUUM EXHAUST SYSTEM AND CLEANING METHOD**

(30) Priority: 15.07.2022 JP 2022114110
(71) Applicant: Edwards Japan Limited, Yachiyo-shi, Chiba 276-8523 (JP)
(72) Inventor: TAKAHASHI, Katsunori, Yachiyo-shi, Chiba 276-8523 (JP); TANAKA, Masarhiro, Yachiyo-shi, Chiba 276-8523 (JP)
(74) Representative: Openshaw & Co.
(86) International application number: PCT/JP2023/025249
(87) International publication number: WO 2024/014405

(57) **Abstract**

A vacuum exhaust system is provided which can reduce consumption of a ClF gas for use in cleaning, and can shorten a cleaning time. An exhaust pipe from a dry pump to an abatement device is provided with a heater, thereby to be heated, so that the temperature of the exhaust pipe is set at a temperature exceeding 180°C. For the exhaust pipe, the pipe and a gasket of a sealing member are also made of a metal. Then, a ClF3 gas for cleaning is introduced. The ClF3 gas is activated at a temperature exceeding 180°C, and cleaning efficiency is remarkably enhanced. On the other hand, the gasket made of a metal is used. For this reason, even when the ClF3 gas is activated, a problem in sealing performance is less likely to be caused. For this reason, it is not necessary to wait until the temperature of the exhaust pipe becomes 180°C or less, which enables shortening of the cleaning time.
FIG. 1
10
CONTROL DEVICE
19
ABATEMENT DEVICE
100
DRY PUMP

FIG. 3

11
PROCESS CHAMBER
19
ABATEMENT DEVICE
100
DRY PUMP

## Description

The present invention relates to a vacuum exhaust system in a semiconductor manufacturing device and a cleaning method therein.

Generally, in a semiconductor manufacturing treatment process, a CVD (Chemical Vapor Deposition) in which a semiconductor, an insulator, a metal film, or the like is deposited on a semiconductor wafer to implement deposition using a chemical gas phase reaction, or a dry etching treatment is performed. In a process chamber, for example, various gases, such as a silane (SiH4) gas, are used. Then, the spent gas (exhaust gas) exhausted from the process chamber is sucked by a dry pump, or the like, and is further introduced into an abatement device via a gas exhaust pipe. A gas abatement treatment is performed at the abatement device.

In such a semiconductor manufacturing treatment process, when the spent gas is cooled, the gas is solidified as a film or a powder to be deposited in the insides of the exhaust pipe other than the process chamber, the dry pump, and the abatement device, which is then deposited to cause pipe blocking. For this reason, maintenance thereof has been often required.

Particularly, to the pipe on the exhaust side of the dry pump, an exhaust gas flows while being pressurized to around the atmospheric pressure. For this reason, the reaction product (which will be hereinafter referred to as a product) resulting from the gas components included in the exhaust gas was deposited considerably in the pipe.

Thus, in order to prevent the deposition of the product, and to remove the deposited product, the pipe is cleaned using a gas. Examples of the gas to be used may include a ClF gas, for example, ClF3 (chlorine trifluoride), as disclosed in Japanese Patent Application Publication No. H02-77579 and Japanese Patent No. 2776700.

Incidentally, for the exhaust pipe of a conventional dry pump, a gasket of an elastomer (a fixing sealing member for allowing a structure to hold airtightness) has been used. For this reason, it has been essential that cleaning gas is passed after a temperature of a pipe becomes 180°C or less. This is because a ClF gas is considerably activated at 180°C or more, which may damage the gasket of an elastomer. Particularly, the ClF3 gas has a high toxicity, hence prevention of damage of the sealing material is very important in terms of ensuring safety.

It is known that, although the ClF3 gas is stable in a glass container up to 180°C so long as the gas is pure, the gas is decomposed in a free radical mechanism when the temperature becomes equal to, or higher than that.

For this reason, cleaning has to be awaited until the temperature of the pipe, which has become high during the treatment, becomes 180°C or less. This has required an extra time for the treatment. Particularly, the pipe is provided with a heat insulating material, and hence cooling with heat radiation has taken a long time.

Further, when the temperature of the pipe becomes 180°C or less, activity of the ClF gas is reduced, resulting in reduction of reactivity with the product. For this reason, a larger amount of gas has to be used.

The invention disclosed in Japanese Patent Application Publication No. H02-77579 relates to a cleaning (washing) method for performing removal using a ClF3 gas in order to remove a reaction product deposited in a reaction vessel in a deposited film forming device for forming a deposited film.

The invention disclosed in Japanese Patent No. 2776700 relates to a cleaning method of cleaning a compound containing a resulting ammonium silicofluoride as a main component, the method being characterized in that the catalytic reaction between the compound and a ClF3 gas or a F2 gas is effected.

The invention disclosed in Japanese Patent No. 3047248 relates to a cleaning method characterized in that, with the inside of a treatment vessel being kept at a treatment temperature of 450°C or more, a cleaning gas containing diluted ClF3 is supplied into the treatment vessel, thereby removing a polysilicon film deposited in the treatment vessel. Further, in the column of (Technical Problem), there is following description: "it is reported that particularly, use of ClF3 enables cleaning even when a plasma state is not achieved; however, ClF3 has a high reactivity, and hence is not considered to be used at 400°C or more, and cleaning is generally performed at 400°C or less; therefore, in the step of performing deposition at 400°C or more, particularly, at 600°C or more, the temperature of the inside of the device has to be decreased to 400°C or less for performing ClF3 cleaning, and this results in a long-term cleaning".

Incidentally, the exhaust pipe (particularly between the dry pump and the abatement device) of the abovementioned treatment vessel is required to be improved in conductance in terms of exhaust efficiency, and has to be increased in diameter. A gasket made of a metal adapted thereto is difficult to develop or manufacture, and hence has not been supplied to the market considerably as far as known.

Further, this tendency was remarkable in a metal gasket adaptable to a flange not in a flange shape as that of a ConFlat flange but of a general ISO standard or KF standard (NW standard), and repeatedly usable.

In recent years, for the abovementioned metal gasket (made of a metal), one usable for the pipe of a flange of a general ISO standard, or KF standard (NW standard) has been developed. For this reason, by using such a metal gasket, it has become possible to keep sufficient sealing characteristics even when the temperature of the exhaust pipe having the abovementioned flange exceeds 180°C. Accordingly, a ClF gas, for example, ClF3 can be activated to be used, and consumption thereof can be decreased, and a cleaning time can be shortened.

Under such circumstances, it is an object of the present invention to provide a vacuum exhaust system and a cleaning method capable of reducing consumption of a ClF gas or shortening a cleaning time by raising the temperature of the exhaust pipe to a temperature higher than 180°C.

With the invention according to aspect 1, there is provided a vacuum exhaust system characterized by being connected with a semiconductor manufacturing device, and including an exhaust pipe for exhausting a gas to an abatement device via a vacuum pump, and characterized in that a sealing member for use in the exhaust pipe is made of a metal, a heating means for heating the exhaust pipe is provided at a site of the exhaust pipe extending from the vacuum pump to the abatement device, and when a cleaning gas including a ClF gas or a NF gas is introduced, the exhaust pipe is heated to a temperature exceeding 180°C by the heating means.

With the invention according to aspect 2, there is provided the vacuum exhaust system according to aspect 1, characterized in that the sealing member is configured using a metal material having a high corrosion resistance against the cleaning gas.

With the invention according to aspect 3, there is provided the vacuum exhaust system according to aspect 1 or 2, characterized in that the exhaust pipe is configured using a metal material having a high corrosion resistance against the cleaning gas.

With the invention according to aspect 4, there is provided a cleaning method for, in a vacuum exhaust system connected with a semiconductor manufacturing device, and including an exhaust pipe for exhausting a gas to an abatement device via a vacuum pump, removing a product deposited on the exhaust pipe by a cleaning gas including a ClF gas or a NF gas, the method including, when the cleaning gas is introduced, heating a site of the exhaust pipe extending from the vacuum pump to the abatement device to a temperature exceeding 180°C.

With the vacuum exhaust system in accordance with the present invention, the exhaust pipe and the sealing member for use in the exhaust pipe are made of a metal, and a ClF gas or a NF gas can be used at high temperatures. For this reason, the consumption thereof can be reduced, and the cleaning time can be shortened.

With the cleaning method in accordance with the present invention, the cooling time of the exhaust pipe is unnecessary, which can shorten the cleaning time.

FIG. 1 is a block view showing a schematic overall configuration of an exhaust gas treatment device in a semiconductor manufacturing treatment process of a vacuum exhaust system in a semiconductor manufacturing device in accordance with an embodiment of the present invention;

FIG. 2 is a schematic side cross sectional view schematically showing an internal structure of a dry pump in accordance with the present embodiment; and

FIG. 3 is a view for illustrating introduction of a cleaning gas of the vacuum exhaust system in a semiconductor manufacturing device in accordance with the present embodiment.

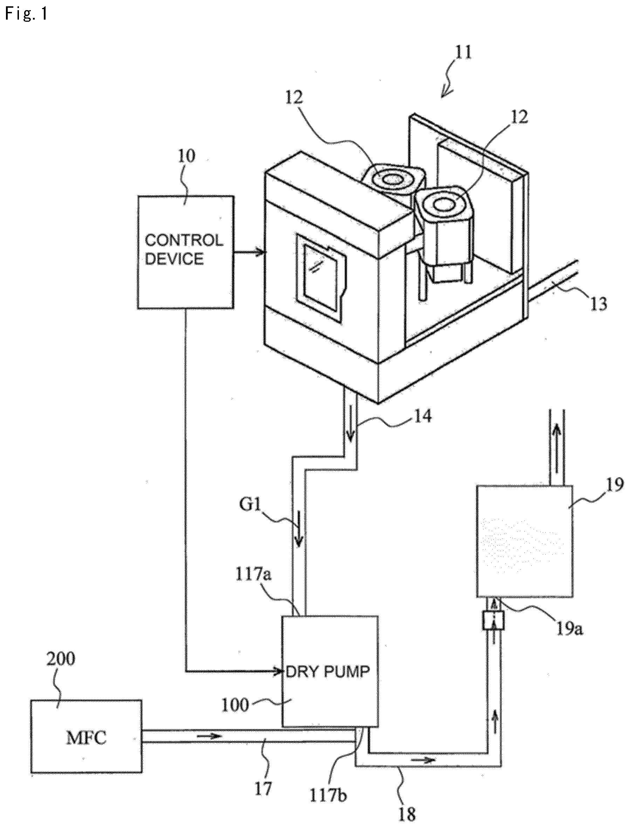

Below, referring to FIGS 1 to 3, preferred embodiments of the present invention will be described in detail.

### (1) Summary of embodiment

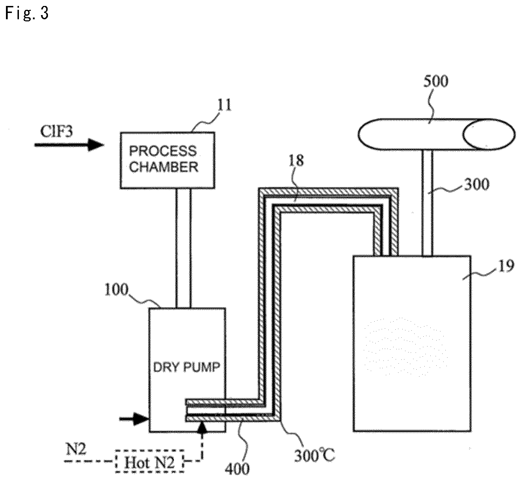

In FIG. 3, an exhaust pipe 18 from a dry pump 100 to an abatement device 19 is provided with a heater 400 (heating means) for heating. Then, the temperature of the exhaust pipe 18 is set at a temperature exceeding 180°C, for example, 300°C. For the exhaust pipe 18, the pipe and the gasket of a sealing member are also made of a metal.

Then, in order to perform cleaning for removing the product, a ClF3 gas is introduced from a process chamber. The ClF3 gas is activated at a temperature exceeding 180°C, so that the cleaning efficiency is remarkably increased. On the other hand, for the exhaust pipe 18, a gasket made of a metal is used. For this reason, even when the ClF3 gas is activated, a problem is less likely to be caused in terms of the sealing performance.

For this reason, it is not necessary to wait until the temperature of the exhaust pipe 18 becomes 180°C or less, which can shorten the time required for cleaning. Further, the activated ClF3 gas can be used. For this reason, the usage can be saved while ensuring the safety.

Incidentally, in the present embodiment, the following is also included: the temperature of the exhaust pipe 18 is set at a temperature exceeding 180°C, for example, 300°C from before cleaning, and the exhaust pipe 18 is continued to be heated to that temperature and is kept also at the time of cleaning.

### (2) Details of embodiment

FIG. 1 is a block view showing a schematic overall configuration of an exhaust gas treatment device in a vacuum exhaust system in a semiconductor manufacturing device in accordance with an embodiment of the present invention.

Referring to FIG. 1, a description will be given to the outline of the overall configuration in the exhaust gas treatment device.

The exhaust gas treatment device is controlled according to the procedure previously determined by a program in a control device 10. In the inside of a process chamber 11, a semiconductor wafer 12 is accommodated, and a process gas for a process treatment, and a cleaning gas (e.g., a gas including a ClF3 gas or a NF gas (nitrogen trifluoride)) for a cleaning treatment are respectively supplied through a gas supply pipe 13.

Then, a dry pump 100 is connected with the process chamber 11 via a gas exhaust pipe 14. The process chamber 11 is configured so as to be reduced in pressure to high vacuum by driving of the dry pump 100.

Namely, for example, a process gas such as a silane (SiH4) gas and a cleaning gas such as ClF3 (chlorine trifluoride), NF3(nitrogen trifluoride), or HCl(hydrogen chloride) processed in the inside of the process chamber 11 (the process gases and the cleaning gases will be hereinafter generically referred to as "spent gas G1") pass through the gas exhaust pipe 14 to be introduced into the downstream dry pump 100.

With the dry pump 100, the spent gas G1 from the process chamber 11 is sucked and taken into the inside of the dry pump 100 through a gas introduction port 117a, and the spent gas G1 is gradually pressurized, for example, in six steps in the inside.

Further, the spent gas G1 pressurized to around the atmospheric pressure in the dry pump 100 is exhausted through the gas outlet port 117b into the exhaust pipe 18, and is fed from the exhaust pipe 18 to the abatement device 19, and is detoxified at the abatement device 19, and then, is exhausted into the atmosphere.

Therefore, one end side of the exhaust pipe 18 is connected with the gas outlet port 117b of the dry pump 100, and the other end side thereof is connected with the gas introduction port 19a of the abatement device 19.

Incidentally, an inert gas (e.g., Hot N2) is introduced through an introduction pipe 17, and the flow thereof is appropriately controlled by a MFC (mass flow controller) 200.

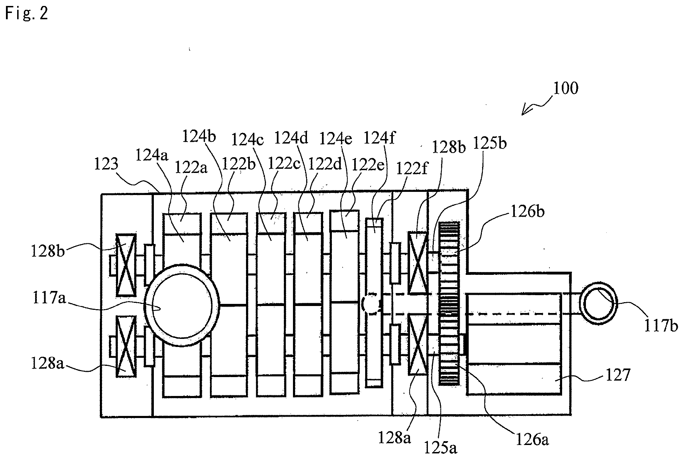

FIG. 2 is a schematic side cross sectional view schematically showing the internal structure of the dry pump 100 in accordance with the present embodiment.

The dry pump 100 shown in FIG. 2 includes a pump casing 123 having a plurality of (6 in the present embodiment) pump chambers 122a, 122b, 122c, 122d, 122e, and 122f, rotors 124a, 124b, 124c, 124d, 124e, and 124f provided in the pump chambers 122a to 122f, respectively, a pair of rotating shafts 125a and 125b to which the rotors 124a to 124f are respectively integrally fixedly installed, and for rotating the rotors 124a to 124f integrally, respectively, a pair of gears 126a and 126b for synchronously rotating the pair of rotating shafts 125a and 125b, a motor 127 as a rotation driving mechanism for rotating the rotating shafts 125a and 125b via the pair of gears 126a and 126b, and bearings 128a and 128b for holding the rotating shafts 125a and 125b, respectively, at the pump casing 123.

Then, a description will be given to the action of the exhaust gas treatment device thus configured.

First, when the dry pump 100 is operated by control of the control device 10, the motor 127 is also driven, so that the rotating shaft 125a is rotated by the motor 127. At this step, the rotating shaft 125b arranged in parallel with the rotating shaft 125a is configured so as to be synchronously rotated by engagement of the gears 126a and 126b, so that the rotating shaft 125b is rotated in the opposite direction to that of the rotating shaft 125a.

Further, the rotation of the rotating shafts 125a and 125b rotates the rotors 124a to 124f integrally fixedly installed to the rotating shaft 125a, and the rotors 124a to 124f integrally fixedly installed to the rotating shaft 125b in reverse to each other in the pump chambers 122a to 122f, respectively. Incidentally, although not shown, the rotors 124a to 124f mounted to the rotating shafts 125a and 125b, respectively in the present embodiment are cocoon type root rotors, and synchronously rotate with a phase difference of 90° while keeping a minute gap therebetween in a non-contact manner with each other.

As a result of this, the spent gas G1 is sucked from the gas introduction port 117a communicating with the to-be-evacuated space to the first-stage pump chamber 122a. Subsequently, the spent gas G1 is sucked sequentially from the first-stage pump chamber 122a to the second-stage pump chamber 122b, the third-stage pump chamber 122c, the fourth-stage pump chamber 122d, and the fifth-stage pump chamber 122e, and is finally exhausted from the dry pump 100 via the exhaust pipe 18 (see FIG. 1) communicating with the gas outlet port 117b of the sixth-stage pump chamber 122f, so that the to-be-evacuated space is rendered in a vacuum state.

At this step, the spent gas G1 is exhausted while being compressed in respective pump chambers 122a, 122b, 122c, 122d, 122e, and 122f. For this reason, the temperature of the spent gas G1 is increased, and the temperature of the pump casing 123 is also increased. Incidentally, of the pump chambers 122a, 122b, 122c, 122d, 122e, and 122f, on the outlet side of the sixth-stage pump chamber 122f at which the difference in pressure of the spent gas G1 between the inlet side and the outlet side is large, the temperature of the spent gas G1 is highest. The temperature of the spent gas G1 herein is set at, for example, a temperature as relatively high as about 150 to 200°C.

Further, the spent gas G1 exhausted from the sixth-stage pump chamber 122f is fed through the exhaust pipe 18 to the abatement device 19 positioned several meters ahead. Then, at the abatement device 19, a prescribed treatment is performed.

FIG. 3 is a view for illustrating the introduction of a cleaning gas of a vacuum exhaust system in a semiconductor manufacturing device in accordance with the present embodiment.

The exhaust pipe 18 for connecting the dry pump 100 and the abatement device 19 is provided with a heater 400, which enables heating of the exhaust pipe 18. For the exhaust pipe 18, the pipe and the gasket of a sealing member are also made of a metal, and the sealing performance can be sufficiently held, for example, even when a ClF3 gas is activated at high temperatures.

As shown with the exhaust gas treatment device in the vacuum exhaust system of FIG. 1, the introduced cleaning gas is sucked from the process chamber 11 to the dry pump 100, and then, is subjected to a prescribed treatment at the abatement device 19, thereby to be detoxicated. Incidentally, the abatement device 19 is also connected with an emergency exhaust device 500 of an installation factory via a bypass line 300.

Herein, the sealing member is configured using a metal material having a high corrosion resistance against a ClF gas or a NF gas (particularly, a ClF3 gas having a high corrosiveness) included in the cleaning gas to be introduced. Specifically, the material is nickel, titanium, SUS316, SUS316L, or the like.

Further, the exhaust pipe 18 is also desirably configured using a metal material having a higher corrosion resistance against a ClF gas or a NF gas included in the cleaning gas to be introduced than that of a general stainless steel material (e.g., SUS304). Specifically, the materials are SUS316, SUS316L, inconel, and the like.

Then, when cleaning is performed, the exhaust pipe 18 for connecting the dry pump 100 and the abatement device 19 is heated by the heater 400. The target temperature is a temperature exceeding 180°C, for example, 300°C.

The ClF3 gas has a property of being stable up to 180°C, and being activated at a temperature exceeding 180°C. The activated ClF3 gas is improved in ability of removing the product, so that the cleaning efficiency is enhanced.

On the other hand, the exhaust pipe 18 uses a gasket made of a metal (not made of a resin). For this reason, even when the ClF3 gas is activated, a problem is less likely to be caused in sealing performance.

For this reason, cleaning is not required to be awaited until the temperature of the exhaust pipe 18 becomes 180°C or less. Immediately after completion of the semiconductor manufacturing step, cleaning can be started, and the time required for the cleaning can be shortened. Further, the control on the time for the temperature also becomes unnecessary.

Further, the ClF3 gas activated at a temperature exceeding 180°C can be used. For this reason, it is possible to save the usage of the ClF3 gas while ensuring the safety.

10 Control device
11 Process chamber
12 Semiconductor wafer
13 Gas supply pipe
14 Gas exhaust pipe
17 Introduction pipe
18 Exhaust pipe
19 Abatement device
19a Gas introduction port
100 Dry pump
117a Gas introduction port
117b Gas outlet port
122a to 122f Pump chamber
123 Pump casing
124a to 124f Rotor
125a, 125b Rotating shaft
126a, 126b Gear
127 Motor (Rotation driving mechanism)
128a, 128b Bearing
200 MFC
300 Bypass line
400 Heater
500 Emergency exhaust device
G1 Spent gas

## Claims

1. A vacuum exhaust system connected with a semiconductor manufacturing device, and comprising an exhaust pipe for exhausting a gas to an abatement device via a vacuum pump, wherein
a sealing member for use in the exhaust pipe is made of a metal,
a heating means for heating the exhaust pipe is provided at a site of the exhaust pipe extending from the vacuum pump to the abatement device, and
when a cleaning gas including a ClF gas or a NF gas is introduced, the exhaust pipe is heated to a temperature exceeding 180°C by the heating means.

2. The vacuum exhaust system according to claim 1,
wherein the sealing member is configured using a metal material having a high corrosion resistance against the cleaning gas.

3. The vacuum exhaust system according to claim 1 or 2,
wherein the exhaust pipe is configured using a metal material having a high corrosion resistance against the cleaning gas.

4. A cleaning method for, in a vacuum exhaust system connected with a semiconductor manufacturing device, and including an exhaust pipe for exhausting a gas to an abatement device via a vacuum pump, removing a product deposited on the exhaust pipe by a cleaning gas including a ClF gas or a NF gas,
the method comprising, when the cleaning gas is introduced, heating a site of the exhaust pipe extending from the vacuum pump to the abatement device to a temperature exceeding 180°C.
